# EUROPÄISCHE PATENTANMELDUNG

(11) **EP 1 496 531 A2**
(43) Veröffentlichungstag der Anmeldung: **12.01.2005**
(21) Anmeldenummer: 04015844.6
(22) Anmeldetag: 06.07.2004
(51) Int. Cl.: H01H 19/00, H03M 1/00

(54) **Sensorvorrichtung zur Erkennung einer Auslösebewegung**

(30) Priorität: 07.07.2003 DE 10330912
(71) Anmelder: E.G.O. ELEKTRO-GERÄTEBAU GmbH, D-75038 Oberderdingen (DE)
(72) Erfinder: Dorwarth, Ralf, Dr., 75038 Oberderdingen (DE)
(74) Vertreter: Patentanwälte Ruff, Wilhelm, Beier, Dauster & Partner

(57) **Zusammenfassung**

Eine Sensorvorrichtung (11) kann ausgebildet sein um eine Auslösebewegung zu erkennen. Die Sensorvorrichtung (11) weist einen Sensor (21, 24) und einen damit zusammenwirkenden länglichen oder kreisrunden Sensorauslöser (13) auf. Der Sensorauslöser weist lange Zwischenbereiche (15) und kurze Zwischenbereiche (16) sowie lange Auslösebereiche (18) und kurze Auslösebereiche (19) auf, die sich jeweils abwechseln. Aus der in einer Steuerung (23) gespeicherten geometrischen Abfolge der Zwischenbereiche und Auslösebereiche kann auf die Richtung einer Relativbewegung zwischen Sensor und Sensorauslöser sowie die Geschwindigkeit und einen zurückgelegten Weg geschlossen werden.

## Beschreibung

Die Erfindung betrifft eine Sensorvorrichtung gemäß dem Oberbegriff des Anspruchs 1 zur Erkennung einer Auslösebewegung, wobei ein Sensor und ein länglicher bzw. langgestreckter Sensorauslöser vorgesehen sind, die zusammenwirken. Dabei kann ein Sensorauslöser beispielsweise im wesentlichen gerade oder auch rund bzw. kreisförmig sein. Zwischen dem Sensor und dem Sensorauslöser kann eine Relativbewegung in beide Richtungen der Länge oder Längserstreckung stattfinden.

Aus der EP 101 4001 A2 und US 6,496,326 ist ein sogenannter magnetischer Schieberregler bekannt. Hier ist es möglich, durch Bewegung eines Sensorauslösers relativ zu dem Sensor eine Auslösung oder Betätigung vorzunehmen.

Aus der EP 797 227 A ist ein Drehregler bekannt. Er entspricht im wesentlichen einem vorgenannten Schieberegler, wobei das Grundprinzip der linearen Bewegung in eine Drehbewegung umgesetzt ist.

Der Erfindung liegt die Aufgabe zugrunde, eine eingangs genannte Sensorvorrichtung weiterzuentwickeln mit neuen Funktionalitäten, welche insbesondere einen vereinfachten Aufbau hat.

Gelöst wird diese Aufgabe durch eine Sensorvorrichtung mit den Merkmalen des Anspruchs 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Erfindungsgemäß ist der Sensorauslöser der eingangs genannten Sensorvorrichtung mit einer Abfolge von Auslösebereichen und Zwischenbereichen versehen, wobei die Bereiche jeweils abwechselnd vorgesehen sind. Der Sensorauslöser bzw. die Auslösebereiche sind erfindungsgemäß derart ausgebildet, dass sie nicht spiegelsymmetrisch sind zu einer Spiegelachse, welche quer zu der Längserstreckung des Sensorauslösers bzw. quer zur Richtung der Relativbewegung verläuft.

Diese nicht spiegelsymmetrische Ausbildung des Sensorauslösers mit den Auslösebereichen und Zwischenbereichen weist den Vorteil auf, dass bei der grundsätzlichen Annahme einer in etwa konstanten Geschwindigkeit der Relativbewegung aufgrund der Abfolge der Auslösebereiche und Zwischenbereiche, welche wegen der fehlenden Spiegelsymmetrie jeweils unterschiedlich lang sind, eine Erkennung der Bewegungsrichtung möglich ist. Im Gegensatz zu den sonstigen Anordnungen von Sensorvorrichtungen dieser Art, welche zwei Sensoren benötigen, wird nur ein einziger Sensor benötigt. Dies bedeutet eine erhebliche Ersparnis nicht nur an Aufwand für den zweiten Sensor an sich, sondern auch für dessen Anordnung, Ansteuerung und Auswertung. In einer Steuereinrichtung, welche für die Ansteuerung und Auswertung des Sensors zuständig ist, muss lediglich das Muster des Sensorauslösers hinterlegt sein, um auf die Richtung der Relativbewegung abhängig von den Zeiten der Auslösung des Sensors zu schließen.

Vorteilhaft ist es vorgesehen, dass die Auslösebereiche abwechselnd länger und kürzer sind. Der Unterschied in der Länge kann den Faktor 2 bis 5, vorteilhaft 3 bis 4, betragen. Besonders bevorzugt sind auch die Zwischenbereiche abwechselnd länger und kürzer. Hier kann der Längenunterschied zwischen langen Zwischenbereichen und kurzen Zwischenbereichen deutlich größer sein, beispielsweise das zwei- bis zehnfache betragen.

Vorteilhaft ist vorgesehen, dass die unterschiedlichen Arten von Bereichen jeweils gleich lang sind. Dies gilt besonders für die Auslösebereiche, so dass sämtliche langen Auslösebereiche und sämtliche kurzen Auslösebereiche jeweils gleich lang sind. Dies gilt bevorzugt auch für die Zwischenbereiche.

Weiterhin kann bezüglich der Längenverhältnisse vorgesehen sein, dass ein kurzer Zwischenbereich in etwa so kurz ist wie ein kurzer Auslösebereich. Die langen Zwischenbereiche sind vorteilhaft länger, insbesondere mehrfach länger, als die langen Auslösebereiche. Als Zahlenwerte können hier Längen im Millimeterbereich genommen werden. So kann beispielsweise ein kurzer Auslösebereich oder Zwischenbereich eine Länge aufweisen, die zwischen 1 mm und 5 mm liegt. Beispielsweise können es zwischen 2mm und 3mm sein. Die langen Auslösebereiche oder Zwischenbereiche weisen eine Länge zwischen 5mm und 20mm auf. Die langen Auslösebereiche weisen beispielsweise eine Länge zwischen 5mm und 10mm auf, die langen Zwischenbereiche beispielsweise zwischen 10mm und 15mm.

Die Längenunterschiede zwischen langen und kurzen Bereichen sowie die Absolutwerte in Millimetern hängen vor allem von der Gesamtausdehnung der Sensorvorrichtung oder des Sensorauslösers ab. Ebenso ist hier zu beachten, welche Auslösung der verwendete Sensor aufweist.

Der Sensorauslöser ist vorteilhaft ein gerader und gleichbleibend breiter Streifen. Die Bereiche erstrecken sich jeweils quer zu der Längsrichtung des Sensorauslösers. Die Richtung der Relativbewegung zwischen ihm und dem Sensor erfolgt besonders vorteilhaft genau entlang seiner Längsachse.

Alternativ zu einer geradlinigen Ausbildung kann der Sensorauslöser gebogen, bogenförmig oder kreisförmig ausgebildet sein. Dabei ist er vorteilhaft kreisrund, so dass er einen geschlossenen Kreis bildet. So kann ein in seiner Erstreckung endloser Sensorauslöser geschaffen werden. Er wird vorteilhaft in einen Drehregler eingesetzt.

Für die Art der Sensorerkennung ergibt es verschiedene Möglichkeiten. Bevorzugt wird eine optische Erkennung. Dabei kann der Sensorauslöser optisch unterschiedliche Bereiche aufweisen als Auslösebereiche und Zwischenbereiche. Beispielsweise können sie einerseits hell und andererseits dunkel sein oder einerseits reflektierend und andererseits matt.

Der Sensor wiederum ist bei einer optischen Sensorvorrichtung vorteilhaft für eine Helligkeitsabtastung ausgebildet. Hierzu kann er einen Lichtsender und einen Lichtempfänger aufweisen. Der Lichtsender strahlt Licht aus gegen den Sensorauslöser. An hellen oder reflektierenden Bereichen des Sensorauslösers, beispielsweise als Auslösebereiche, wird das Licht reflektiert und von dem Lichtempfänger registriert. So können die unterschiedlichen Bereiche in Sensorsignale bzw. elektrische Impulse umgewandelt werden.

Weitere Möglichkeiten sind magnetisch mit Magneten und beispielsweise Hall-Sensoren, wie es aus der eingangs genannten EP 797 227 A hervorgeht. Es sind auch induktive oder kapazitive Sensorauslöser und Sensoren möglich.

Es ist von Vorteil, wenn der Sensor einerseits eine möglichst hohe Sensorauslösung aufweist. Dies ermöglicht es, die Bereiche relativ schmal auszubilden. Dadurch ist die Abfolge von Bereichen bei der Relativbewegung durch einen Bediener relativ schnell, so dass hierdurch auch Geschwindigkeitsunterschiede erkannt und bei der Auswertung berücksichtigt werden können.

Der Sensor ist vorteilhaft mit einer Steuerung verbunden, welche aufgrund der Dauer der Erkennung eines Auslösebereichs oder eines Zwischenbereichs die Geschwindigkeit der Relativbewegung erkennen oder berechnen kann. Des weiteren kann mit der Steuerung erkannt werden, wie die Abfolge von unterschiedlichen langen Auslösebereichen und unterschiedlich langen Zwischenbereichen ist. Ist dieses Muster bekannt, kann damit auf Richtung und zurückgelegte Entfernung der Relativbewegung geschlossen werden. Dies ermöglicht insgesamt zum einen eine Bestimmung der Auslösebewegung hinsichtlich Weg. Soll durch die Auslösebewegung eine Einstellung verschiedener Punkte oder Stufen erreicht werden, können diese vorteilhaft das ein- oder mehrfache kurzer oder langer Auslösebereiche betragen.

Ein mögliches Anwendungsbeispiel für eine erfindungsgemäße Sensorvorrichtung ist ein Einbau in einen Schieberregler, welcher eine berührungslose Erkennung aufweist. Ein solcher Schieberregler oder Drehregler kann sehr vielfältig verwendet werden, beispielsweise als Leistungseinsteller für Elektrogeräte, beispielsweise Kochfelder mit einer Vielzahl von Kochstufen, beispielsweise neun Kochstufen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigen:
- Fig. 1: eine Draufsicht auf eine Sensorvorrichtung mit einem Sensorauslöser, der in helle Auslösebereiche und dunkle Zwischenbereiche unterteilt ist, und mit einem optischen Sensor,
- Fig. 2: eine seitliche Darstellung einer weiteren Sensorvorrichtung, bei der die Auslösebereiche und Zwischenbereiche unterschiedliche Höhen haben und mechanisch abgetastet werden und
- Fig. 3: eine Darstellung eines Drehknebels von schräg unten.

### Detaillierte Beschreibung der Ausführungsbeispiele

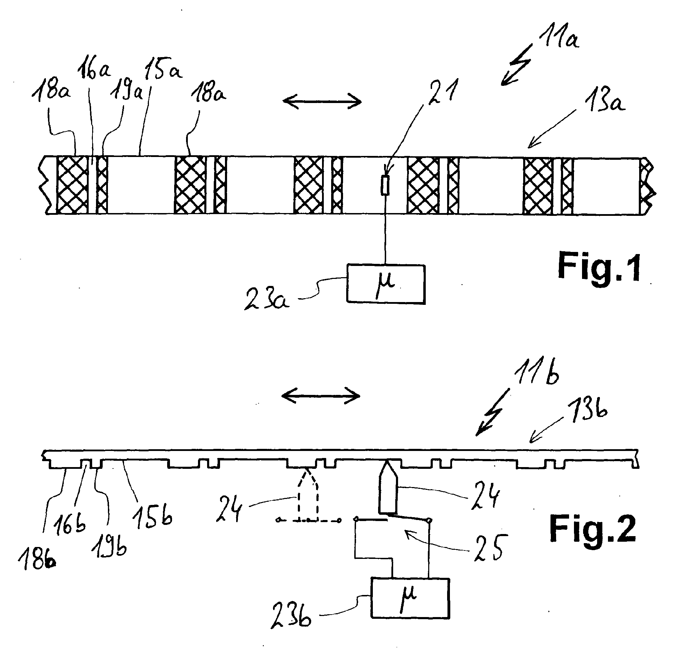

In Fig. 1 ist eine Sensorvorrichtung 11a dargestellt. Sie weist einen Sensorauslöser 13a auf in langgestreckter Streifenform. Der Sensorauslöser 13a weist einerseits lange Zwischenbereiche 15a und kurze Zwischenbereiche 16a auf. Des weiteren weist er lange Auslösebereiche 18a und kurze Auslösebereiche 19a auf. Diese sind abwechselnd vorgesehen, wie Fig. 1 zeigt. Es ist zu erkennen, wie sich Zwischenbereiche 15a bzw. 16a und Auslösebereiche 18a bzw. 19a abwechseln. Des weiteren ist die dargestellte Abfolge diejenige, dass neben einem langen Zwischenbereich 15a ein langer Auslösebereich 18a angeordnet ist. Dann kommt ein kurzer Zwischenbereich 16a und ein kurzer Auslösebereich 19a, usw. Die verschiedenen Arten von Zwischenbereichen oder Auslösebereichenhaben jeweils genau die gleiche Länge.

Des weiteren ist ein optischer Sensor 21 vorgesehen zur Erfassung oder optischen Abtastung des Sensorauslösers 13a. Der optische Sensor 21 ist dabei mit einer Steuerung 23a verbunden, welche ihn ansteuert und seine Signale auswertet.

Wie in Fig. 1 dargestellt ist, sollte der optische Sensor 21 klein sein, selbst gegenüber der Breite der kurzen Zwischenbereiche 16a und kurzen Auslösebereiche 19a. Dies ist wichtig für die Auslösegenauigkeit.

Zwischen Sensorauslöser 13a und optischem Sensor 21 findet eine Relativbewegung statt entlang der Richtung, welche durch den Pfeil definiert ist. Welcher Teil sich hier gegen welchen bewegt, oder ob sich beide bewegen, ist an sich im Rahmen der Erfindung ohne Bedeutung.

Der optische Sensor 21 kann beispielsweise eine Reflektionsfunktionsweise aufweisen. Das bedeutet, dass entweder von außen eingestrahltes Licht von dem Sensorauslöser 13a, je nach Zwischenbereich oder Auslösebereich, unterschiedlich reflektiert und von dem Sensor 21 erfasst und ausgewertet wird. Des weiteren kann der optische Sensor 21 selbst eine entsprechende Lichtquelle und einen entsprechenden Lichtempfänger aufweisen.

Alternativ zu einem reflektierenden Sensorauslöser 13a könnte bei einer optisch arbeitenden Erkennung auch ein unterschiedlich durchsichtiger Sensorauslöser verwendet werden. Insbesondere kann er mit einer Durch-Lichtschranke verwendet werden.

Wie zuvor beschrieben, könnten auch als Auslösebereiche 18a und 19a Magnete verwendet werden. Anstelle des optischen Sensors 21a würde dann ein Hallsensor verwendet werden. Ebenso können induktive oder kapazitive Auslösebereiche vorgesehen sein.

Bei der weiteren Sensorvorrichtung 11b gemäß Fig. 2 ist keine optische sondern eine mechanische Abtastung vorgesehen. Der Sensorauslöser 13b ist wiederum in lange Zwischenbereiche 15b und kurze Zwischenbereiche 16b sowie lange Auslösebereiche 18b und kurze Auslösebereiche 19b unterteilt. Wie deutlich zu erkennen ist, sind diese in Vorsprünge und/oder Vertiefungen unterteilt, wobei die Auslösebereiche 18b und 19b die Vorsprünge bilden.

Als Sensor zur mechanischen Abtastung ist ein Abtaster 24 vorgesehen, welche elastisch gegen den Sensorauslöser 13b gedrückt wird. Der Abtaster 24 ist derart mit einem Schalter 25b und einer Steuerung 23b verbunden, dass er den Schalter in Abhängigkeit davon schließt, ob er an einem Zwischenbereich oder einem Auslösebereich anliegt.

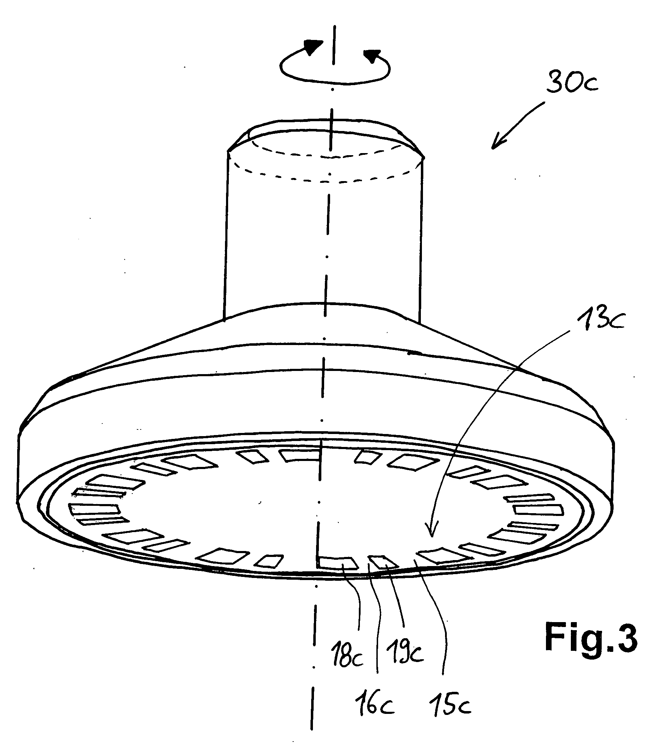

In Figur 3 ist in der Darstellung von schräg unten ein sogenannter Drehknebel 30c dargestellt. Ein solcher Drehknebel ist beispielsweise aus der EP 797 227 A bekannt, auf die hiermit ausdrücklich Bezug genommen wird. Durch eine Drehbewegung um eine strichpunktierte senkrechte Drehachse soll eine Einstellung vorgenommen werden, beispielsweise zur Einstellung der Energiezufuhr bei einer Strahlungsheizung eines Kochfeldes.

An der Unterseite des Drehknebels 30c ist ein Sensorauslöser 13c in Kreisform angeordnet. Dem Erfindungsprinzip entsprechend ist der Sensorauslöser 13c in lange und kurze Zwischenbereiche 15c und 16c sowie lange und kurze Auslösebereiche 18c und 19c aufgeteilt. Im Prinzip entspricht der Sensorauslöser 13c einer Anordnung gemäß Figur 1, nur eben nicht in gerader Form sondern in runder bzw. Kreisform.

Die Lagerung des Drehknebels 30c kann, wie in der oben genannten EP 797 227 A beschrieben, magnetisch erfolgen und nicht mit einer starren Achse. Insofern sind zwar durch Magnetkräfte gewisse Beharrungswirkungen entlang der Drehachse gegeben. Allerdings sind diese Kräfte auch nicht besonders groß. Insofern ist es bei einem solchen Drehknebel 30c bzw. bei einer solchen Sensorvorrichtung 11c von Vorteil, keine mechanische Abtastung zu verwenden. Ansonsten stehen jedoch die zuvor genannten Möglichkeiten zur Verfügung, nämlich magnetisch mittels Hallsensoren, kapazitiv oder induktiv sowie optisch. Alternativ ist es möglich, den Drehknebel 30c mit einer festen Drehachse bzw. Drehlagerung zu versehen.

Bezüglich der Funktion unterscheidet sich die Sensorvorrichtung 11c gemäß Figur 3 im Prinzip nicht von denjenigen aus den Figuren 1 und 2. Was dort für die geradlinige Ausbildung und eine Bewegung entlang dieser Ausdehnungsrichtung gilt, ist bezüglich der Sensorvorrichtung 11c gemäß Figur 3 in Umfangsrichtung gültig.

### Funktion

Das Funktionsprinzip der beiden Sensorvorrichtungen 11a und 11b gemäß Fig. 1 und 2 ist dasselbe. Ein Sensorauslöser 13 ist in lange und kurze Zwischenbereiche 15 und 16 sowie lange und kurze Auslösebereiche 18 und 19 aufgeteilt. Zur Unterscheidung dieser verschiedenen Bereiche ist ein Sensor vorgesehen. Das Auslösevermögen des Sensors sollte dabei unterhalb der kürzersten Breite eines der Bereiche liegen.

Mit einer Sensorvorrichtung 11 gemäß den Fig. 1 und 2 ist es im Prinzip möglich, die Richtung einer Bewegung zu bestimmen, welche relativ zwischen Sensorauslöser 13 und optischem Sensor 21 bzw. Abtaster 24 stattfindet. Des weiteren ist es von Vorteil, wenn der zurückgelegte Weg der Bewegung zumindest in gewissen Grenzen bestimmt werden kann.

Ausgehend von der Stellung zwischen Sensorauslöser 13 und Sensor 21 oder Abtaster 24 wird der Sensorauslöser als bewegliches Teil beispielsweise nach rechts bewegt. Dann erfasst der optische Sensor 21 zuerst den links von ihm liegenden kurzen Auslösebereich 19a und gibt ein entsprechendes Signal an die Steuerung 23a. Anschließend fährt ein kurzer Zwischenbereich 16a an dem Sensor 21 vorüber, wiederum gefolgt von einem langen Auslösebereich 18a. Dann kommt ein langer Zwischenbereich 15a und daraufhin wieder ein kurzer Auslösebereich 19a. Da die jeweiligen Ausdehnungen der Zwischenbereiche und Auslösebereiche in der Steuerung 23a abgespeichert oder bekannt sind, kann aufgrund der Zeiten, mit welchen sich die verschiedenen Bereiche abwechseln bzw. die davon bewirkten Auslösungen, auf die Geschwindigkeit der Relativbewegung geschlossen werden.

Des weiteren kann aus der Reihenfolge der verschiedenen Bereiche bzw. einer von diesen bewirkten Auslösung oder nicht auf die Richtung der Relativbewegung geschlossen werden. Kommt zuerst ein kurzer Auslösebereich und dann ein kurzer Zwischenbereich und dann ein langer Auslösebereich und dann ein langer Zwischenbereich, so läuft der Sensorauslöser 13a im Vergleich zum Sensor 21 nach rechts. Ist die Reihenfolge andersherum, so läuft der Sensorauslöser 13a nach links. Genauso verhält es sich mit dem Sensorauslöser 13b der Sensorvorrichtung 11b.

Die Ausdehnungen der verschiedenen Auslösebereiche und Zwischenbereiche im Verhältnis zu der Sensorauslösung sowie der Gesamtbewegung sollte derart sein, dass die gewünschte Auslösung der Relativbewegung nicht zu eng ist. Für eine sichere Auslösung sollte davon ausgegangen werden können, dass die Geschwindigkeit der Relativbewegung nicht zu sehr schwankt, bzw. wenn sie schwankt, dann nur jeweils nach Durchlaufen einer kompletten Abfolge von Zwischenbereichen und Auslösebereichen.

## Patentansprüche

1. Sensorvorrichtung (11) zur Erkennung einer Auslösebewegung, mit einem Sensor (21, 24) und einem damit zusammenwirkenden länglichen oder runden Sensorauslöser (13), wobei zwischen dem Sensor (21) und dem Sensorauslöser (13) eine Relativbewegung stattfindet mit Hin- und Zurückrichtung, wobei der Sensorauslöser eine Abfolge von Auslösebereichen (18, 19) und Zwischenbereichen (15, 16) aufweist, **dadurch gekennzeichnet, dass** der Sensorauslöser (13) bzw. die Auslösebereiche (18, 19) nicht spiegelsymmetrisch ausgebildet sind in Richtung der Relativbewegung bzw. zu einer Spiegelachse quer zu der Richtung der Relativbewegung.

2. Sensorvorrichtung nach Anspruch 1, **dadurch gekennzeichnet, dass** die Auslösebereiche (18, 19) abwechselnd länger und kürzer sind, wobei vorzugsweise auch die Zwischenbereiche (15, 16) abwechselnd länger und kürzer sind.

3. Sensorvorrichtung nach Anspruch 1 oder 2, **dadurch gekennzeichnet, dass** lange Auslösebereiche (18) jeweils genau gleich lang sind und kurze Auslösebereiche (19) jeweils gleich lang sind, insbesondere auch lange und kurze Zwischenbereiche (15, 16) jeweils genau gleich lang sind.

4. Sensorvorrichtung nach einem der vorhergehenden Ansprüche, **dadurch gekennzeichnet, dass** ein Zwischenbereich (16) zwischen zwei Auslösebereichen (18, 19) kurz ist, wobei er vorzugsweise in etwa so kurz ist wie ein kurzer Auslösebereich (19).

5. Sensorvorrichtung nach einem der vorhergehenden Ansprüche, **dadurch gekennzeichnet, dass** die langen Zwischenbereiche (15) länger sind, insbesondere mehrfach länger, als die langen Auslösebereiche (18).

6. Sensorvorrichtung nach einem der vorhergehenden Ansprüche, **dadurch gekennzeichnet, dass** der Sensorauslöser (13a, 13b) ein gerader und gleichbleibend breiter Streifen ist.

7. Sensorvorrichtung nach einem der Ansprüche 1 bis 5, **dadurch gekennzeichnet, dass** der Sensorauslöser (13c) gebogen, bogenförmig oder kreisförmig ausgebildet ist, wobei er vorzugsweise kreisrund ist und einen geschlossenen Kreis bildet.

8. Sensorvorrichtung nach einem der vorhergehenden Ansprüche, **dadurch gekennzeichnet, dass** die Sensorvorrichtung (11) mit optischer Erkennung arbeitet, wobei der Sensorauslöser (13) optisch unterschiedliche Bereiche aufweist als Auslösebereiche (18, 19) und Zwischenbereiche (15, 16), wobei sie vorzugsweise einerseits hell und andererseits dunkel sind.

9. Sensorvorrichtung nach Anspruch 8, **dadurch gekennzeichnet, dass** der Sensor (21) für eine Helligkeitsabtastung ausgebildet ist, vorzugsweise mit einem Lichtsender und einem Lichtempfänger, wobei der Lichtempfänger Licht empfängt, welches von dem Lichtsender gegen den Sensorauslöser (13) abgestrahlt und reflektiert ist.

10. Sensorvorrichtung nach einem der Ansprüche 1 bis 7, **dadurch gekennzeichnet, dass** der Sensorauslöser (13) mit elektromagnetischer Erkennung arbeitet, insbesondere magnetischer, induktiver oder kapazitiver Erkennung.

11. Sensorvorrichtung nach einem der vorhergehenden Ansprüche, **dadurch gekennzeichnet, dass** der Sensor (21) mit einer Steuerung (23) verbunden ist, die dazu ausgebildet ist, aufgrund der Dauer der Erkennung eines Auslösebereichs (18, 19) oder eines Zwischenbereichs (15, 16) auf die Geschwindigkeit der Relativbewegung zu schließen und/oder auf die Abfolge von unterschiedlich langen Auslösebereichen (18, 19) und Zwischenbereichen (15, 16) und damit auf die Richtung und die zurückgelegte Entfernung der Relativbewegung.

12. Sensorvorrichtung nach einem der vorhergehenden Ansprüche, **dadurch gekennzeichnet, dass** sie zum Einbau in einen Schieberegler oder Drehregler mit berührungsloser Erkennung ausgebildet ist.
